# EUROPÄISCHE PATENTSCHRIFT

(11) **EP 1 448 378 B1**
(45) Veröffentlichungstag und Bekanntmachung des Hinweises auf die Patenterteilung: **19.04.2006**
(21) Anmeldenummer: 02778972.6
(22) Anmeldetag: 10.10.2002
(51) Int. Cl.: B32B 15/08, B32B 15/20, B32B 7/06, H05K 3/02

(54) **TRENNPLATTEN-VERBUNDKOMPONENTE ZUR HERSTELLUNG VON LEITERPLATTENKOMPONENTEN UND VERFAHREN ZUR HERSTELLUNG EINER SOLCHEN VERBUNDKOMPONENTE**
SEPARATING PLATE-COMPOSITE COMPONENT FOR PRODUCING PRINTED CIRCUIT BOARD COMPONENTS AND METHOD FOR PRODUCING A COMPOSITE COMPONENT OF THIS TYPE
COMPOSANT COMPOSITE A CARTE DE SEPARATION POUR PRODUIRE DES COMPOSANTS DE CARTES DE CIRCUIT ET PROCEDE POUR PRODUIRE UN COMPOSANT DE CE TYPE

(30) Priorität: 14.11.2001 AT 17972001
(43) Veröffentlichungstag der Anmeldung: 25.08.2004
(73) Patentinhaber: C2C Technologie für Leiterplatten GmbH, 8700 Leoben-Hinterberg (AT)
(72) Erfinder: TOMASCHITZ, Klaus, A-8700 Leoben (AT); BACKHAUS, Ernst-Dieter, 79350 Sexau (DE)
(74) Vertreter: Sonn & Partner Patentanwälte
(86) Internationale Anmeldenummer: PCT/AT2002/000292
(87) Internationale Veröffentlichungsnummer: WO 2003/041956

(56) Entgegenhaltungen:
- WO-A-85/03669
- DE-A- 3 541 977
- US-A- 4 875 283
- US-A- 5 153 050

## Beschreibung

Die Erfindung betrifft eine Trennplatten-Verbundkomponente zum Herstellen von Leiterplattenkomponenten unter Verpressen von mit zumindest einer solchen Verbundkomponente gestapelten Einzellagen, welche Verbundkomponente eine Trennplatte zwischen Kupferfolien aufweist.

Die Erfindung betrifft auch ein Verfahren zum Herstellen einer solchen Verbundkomponente.

Zur Herstellung von aus mehreren Lagen gebildeten Leiterplattenkomponeten, insbesondere von sogenannten Multilayer-Leiterplatten oder kurz Multilayers, ist es bekannt, Einzellagen-Presspakete in entsprechenden Etagen- oder Vakuumpressen bei einer Temperatur von z.B. ca. 180°C miteinander zu verbinden. Die einzelnen Anordnungen bestehen aus Kupferfolien, die zur Herstellung der Leiterbahnen erforderlich sind, sowie aus Kunstharzschichten (Prepreg-Schichten, üblicherweise Epoxyharz-Schichten) bzw. Laminatschichten. Dabei werden in der Regel mehrere derartige Presspakete übereinander in einer Presse angeordnet, und diese Pakete werden durch Trenn- oder Pressplatten voneinander getrennt. Diese Trennplatten haben vor allem die Aufgabe, eine einheitliche Druck- und Temperaturverteilung beim Pressen der Multilayer herbeizuführen, um so qualitativ hochwertige Leiterplattenprodukte zu erzielen. Die Trennplatten bestehen zumeist aus einem Stahlblech oder aber aus Aluminiumblech und werden deshalb auch Trennbleche genannt. Aufgrund der beschriebenen Funktion sollen sie härter sein als die Kupferfolien. Eine den Multilayer-Leitplatten vergleichbare Herstellung ist bei den sogenannten Basismaterialien für Leiterplatten denkbar, bei denen es sich üblicherweise um eine Kunstharzschicht (Prepreg-Schicht) handelt, die einseitig oder beidseitig mit einer leitenden Schicht (insbesondere einer Kupferfolie) kaschiert ist. Diese Basismaterialien werden auch als sogenannte "Innenlagen" bei der Herstellung von Multilayer-Leiterplatten verwendet und bilden für sich ebenfalls Leiterplattenkomponenten.

Die Trennplatten oder Trennbleche sind relativ herstellungs- und kostenaufwendige Komponenten im Zuge der beschriebenen Leiterplattenherstellung, so dass ihre mehrmalige Verwendung gewünscht ist. Dem steht jedoch häufig entgegen, dass beim Verpressen der Einzellagen, beim Erhitzen des Kunstharzmaterials in den Prepreg-Schichten, ein Ausfließen des Kunstharzmaterials über die Ränder der Trennplatten, zum Teil auch über größere Flächenbereiche der Trennplatten, erfolgt, wobei dieses Kunstharzmaterial nach dem Erkalten und Erstarren kaum mehr von den Trennplatten entfernt werden kann. Dies trifft beispielsweise auf die Verbundkomponenten gemäß US 5 153 050 A zu, wo eine Aluminiumplatte als Trennplatte verwendet wird, wobei auf diese Aluminiumplatte Kupferfolien direkt über einen randseitigen Klebestreifen aufgeklebt werden. Dieser Klebestreifen hält zwar Staubpartikel des Kunstharzes von einem Eindringen ab, jedoch kann ein Verschmutzen der Trennplatte an den Kanten durch das flüssige Kunstharz nicht vermieden werden. Ein weiteres Problem sind hier auch die unterschiedlichen Wärmeausdehnungskoeffizienten von Aluminium und Kupfer, so dass sich beim Verpressen Wärmespannungen im Cu-Al-Cu-Laminat ergeben.

In der DE 198 31 461 C wird eine Verbundkomponente vorgeschlagen, bei der ein Aluminium-Trennblech zwischen zwei vergleichsweise größeren Kupferfolien eingeschlossen wird, wobei die Kupferfolien außerhalb des Aluminium-Trennblechs sackartig miteinander durch Verkleben verbunden werden. Damit kann das flüssige Kunstharz vom Aluminium-Trennblech ferngehalten werden, und überdies können sich auch die Kupferfolien und das Aluminium-Trennblech entsprechend ihrem verschiedenen Wärmeausdehnungskoeffizienten unterschiedlich dehnen, wenn beim Pressen die Temperatur auf beispielsweise ca. 180°C erhöht wird. Allerdings können die Kupferfolien des Kupferfoliensacks nicht harzbeschichtet sein, da das Harz beim Pressen flüssig werden und über den Rand hinausfließen würde, wobei in der Presse ungewollte Verklebungen verursacht werden könnten. Außerdem müssen nach dem Pressen die überstehenden Randbereiche der Kupferfolien abgeschnitten und entfernt werden, wobei ein Recycling dieser Kupferfolien durch das beim Verpressen auf sie gelangende Kunstharzmaterial problematisch ist.

Aus der DE 35 41 977 A ist ein Mehrschicht-Laminat zum Verpressen von gedruckten Schaltungsteilen, als Leiterplatten, bekannt. Dieses Mehrschicht-Laminat enthält als wesentlichen Bestandteil nachgiebige Ausgleichsfolien bzw. Polstermaterial in einem Verbund-Bauteil, der außen noch Trennschichten, z.B. aus Kupfer, mit dünnen äußeren Antihaftschichten aufweist.

Diese Mehrschicht-Laminate werden im Einzelnen dazu eingesetzt, mit einem Kleber versehene Folien auf vorgefertigte Leiterplatten aufzupressen.

Es ist nun Aufgabe der Erfindung, eine Trennplatten-Verbundkomponente sowie ein vorteilhaftes Verfahren zur Herstellung einer solchen Verbundkomponente vorzuschlagen, wobei ungewollte Verklebungen durch flüssiges Harz beim Verpressen der Einzellagen auf einfache Weise vermieden werden, und wobei auch der Einsatz von Harz-beschichteten Kupferfolien für die Verbundkomponente - zwecks Verbinden mit den benachbarten Einzellagen - ermöglicht wird. Diese Verbundkomponenten sollen dabei nichtsdestoweniger einfach und kostengünstig herstellbar sein.

Zur Lösung dieser Aufgabe sieht die Erfindung eine Trennplatten-Verbundkomponente wie in Anspruch 1 definiert vor.

Vorteilhafte Ausführungsformen und Weiterbildungen dieser Verbundkomponente sind in den von Anspruch 1 abhängigen Ansprüchen definiert.

Weiters sieht die Erfindung in vorteilhafter Weise ein Verfahren wie im unabhängigen Verfahrensanspruch definiert vor.

Bei der erfindungsgemäßen Technik wird das aus dem Einzellagen-Paket ausfließende Harz von den Antihaftlagen an der Trennplatte aufgefangen, und ein Verkleben bzw. ein Verschmutzen der Trennplatte wird zuverlässig vermieden. Dies trifft auch dann zu, wenn die Kupferfolien, wie dies bevorzugt wird, auf ihren von den Antihaftlagen abgelegenen Seiten mit Harz beschichtet sind. Die Kupferfolien werden an den Antihaftlagen einfach angeklebt, z.B. mit Hilfe eines druckempfindlichen Klebers bzw. eines Schmelzklebers, insbesondere eines Heißschmelzklebers, der eine ausreichende Haftung an den Antihaftlagen für den Pressvorgang gewährleistet, danach jedoch ein Ablösen der Kupferfolien ermöglicht. Eine vorteilhafte Variante ist hier durch einen an sich handelsüblichen Acrylatkleber gegeben, der sich beim Verpressen, bei den dabei angewandten Temperaturen, zersetzt. Die Antihaftlagen werden auch als Trennlagen oder Trennschichten bezeichnet, und sie haben die Funktion, das flüssige Harz aufzunehmen und so ein Anhaften dieses flüssigen Harzes an der Trennplatte zu verhindern. Insofern ist auch das beschriebene Ankleben der Kupferfolien an diesen Antihaftlagen durchaus möglich, wobei geeignete Klebstoffe im Stand der Technik hinlänglich bekannt sind. Im Wesentlichen können hier die meisten bekannten druckempfindlichen Kleber bzw. Schmelzkleber eingesetzt werden.

Die Trennplatte kann in an sich bekannter Weise aus einem Stahlblech oder aber aus einem Aluminiumblech bestehen, wobei ein Stahlblech oder Edelstahlblech, insbesondere mit einer Festigkeit vom mindestens 400 MPa, bevorzugt wird. Sie kann jedoch aus anderen geeigneten harten Materialien (außer Metall) hergestellt werden, wobei nur wichtig ist, dass sie härter ist als die aufzulaminierende Kupferfolie, um sogenannte Image-Transfers beim Pressvorgang zu vermeiden, d.h. ein Durchdrücken der Leiterbahnen der Innenlagen durch die äußeren Kupferfolien.

Eine vorteilhafte Ausführungsform der erfindungsgemäßen Verbundkomponente zeichnet sich dadurch aus, dass die Antihaftlagen durch gesonderte Trennfolien gebildet sind, die mit einem Randbereich über die Trennplatte vorstehen und in diesen vorstehenden Randbereichen miteinander verbunden sind, wodurch die Trennplatte in einem Trennfoliensack eingeschlossen ist. Dabei kann die Trennplatte im Inneren des Trennfoliensacks frei beweglich sein. Die Trennfolien können hier aus einem Kunststoffmaterial, wie z.B. aus PET oder Polypolymeren, bestehen. Je nach dem Material der beiden Trennfolien können diese mit Hilfe eines passenden Klebers über eine Klebenaht miteinander verbunden sein. Die Klebenaht des Trennfoliensacks kann bevorzugt mit Hilfe eines handelsüblichen Acrylatklebers, druckempfindlichen Klebers oder Schmelzklebers hergestellt werden, der im Randbereich der Trennfolien in Form eines kontinuierlichen Streifens aufgebracht wird.

Andererseits wird eine herstellungsmäßig und kostenmäßig besonders günstige Verbundkomponente ermöglicht, wenn die Antihaftlagen durch auf die beiden Seiten der Trennplatte aufgebrachte Antihaft-Beschichtungen gebildet sind, und wenn die Trennplatte samt Antihaft-Beschichtungen über die Kupferfolie allseitig vorsteht. Bei dieser Ausführungsform ist somit die Trennplatte mit der darauf angebrachten Antihaft-Beschichtung größer als die Kupferfolien, so dass auf ihr bzw. genauer auf den auf ihr aufgebrachten Antihaft-Beschichtungen ein ausfließendes Kunstharz aufgefangen werden kann. Demgegenüber kann bei der zuvor angeführten Ausführungsform mit der Trennplatte innerhalb des Trennfoliensacks eine gleiche Größe von Trennplatte und Kupferfolien vorliegen, da dann die Trennfolien über die Ränder der Trennplatte und der Kupferfolien vorstehen und so zum Auffangen des ausfließenden Kunstharzes dienen können.

Die Antihaft-Beschichtungen können aus den verschiedensten Materialen gebildet sein, wie etwa aus Teflon oder einem Polyolefin oder aber auch aus einem Lack.

Die Erfindung wird nachstehend anhand eines in der Zeichnung dargestellten besonders vorteilhaften Ausführungsbeispiels, auf das sie jedoch nicht beschränkt sein soll, noch weiter erläutert. Es zeigen im Einzelnen:
Fig. 1 in einer schematischen Ansicht einen Aufbau eines Multilayer-Presspakets mit mehreren Einzellagen und Trennplatten-Verbundkomponenten;
Fig. 2 schematisch in einer Ansicht eine Trennplatten-Verbundkomponente mit einem Trennfoliensack;
Fig. 3 eine schematische Draufsicht auf eine derartige Verbundkomponente gemäß Fig. 2;
Fig. 4 eine schematische Ansicht einer anderen Ausführungsform einer Trennplatten-Verbundkomponente, mit direkt mit AntihaftSchichten versehenem Trennblech; und
Fig. 5 eine Draufsicht auf eine derartige Verbundkomponente gemäß Fig. 4.

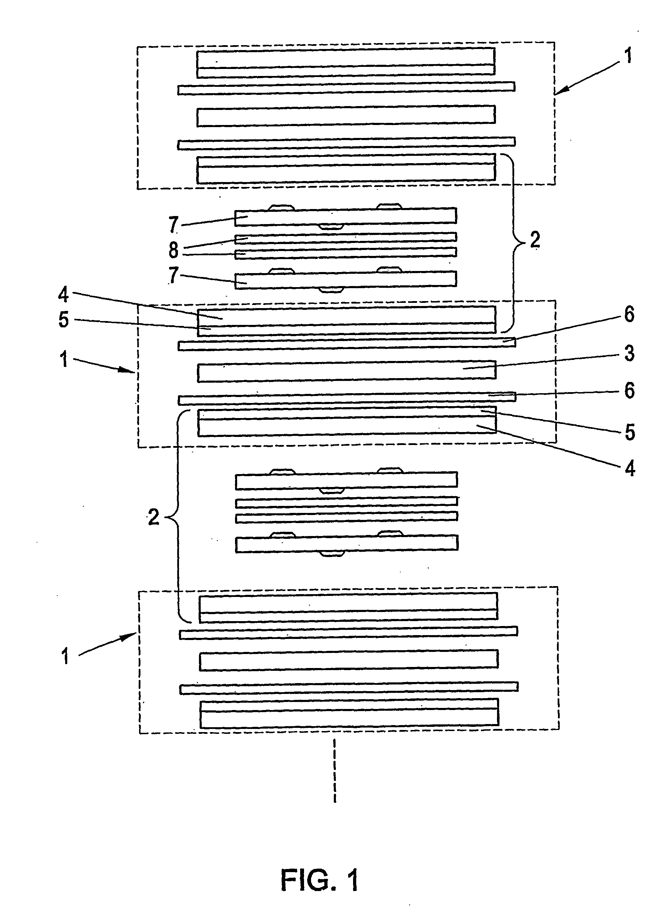

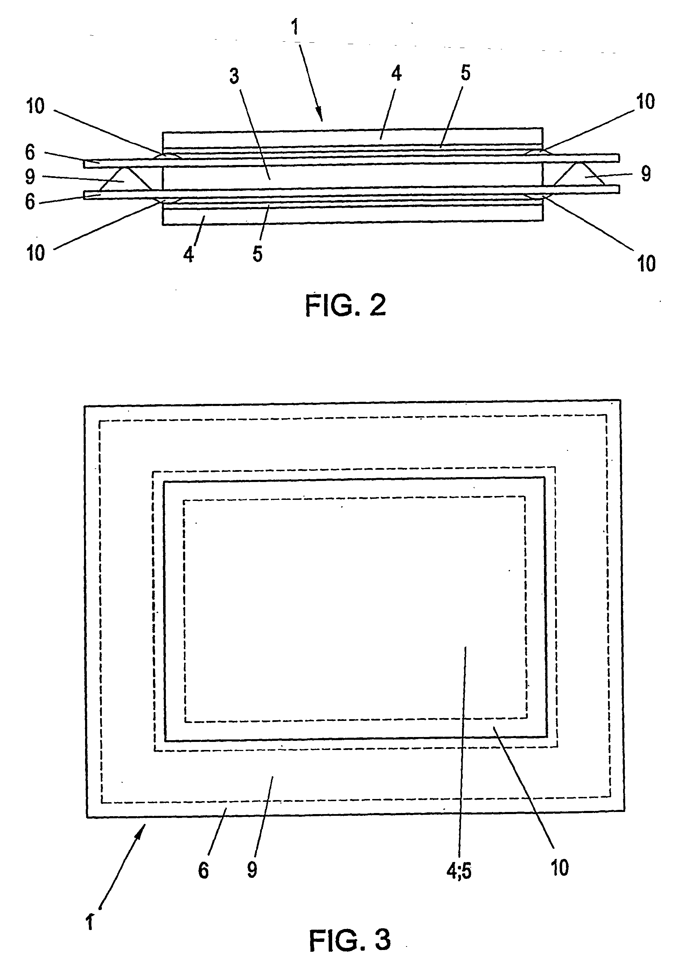

In Fig. 1 ist ein Multilayer-Presspaket schematisch und ausschnittsweise gezeigt, wobei ersichtlich ist, dass Trennplatten-Verbundkomponenten 1 mit Einzellagen-Anordnungen 2 für Multilayer-Leiterplatten, nachstehend kurz Anordnungen 2 genannt, abwechseln. Die mit strichlierten Rechtecken veranschaulichten Trennplatten-Verbundkomponenten 1 weisen je eine Trennplatte 3, auch Pressplatte, Trennblech oder Pressblech genannt, auf, an der mit einer Harzschicht 4 versehene Kupferfolien 5 über Antihaftlagen 6, hier in Form von Trennfolien, angebracht werden. Die gesamte Einheit mit harzbeschichteter Kupferfolie 5,4, Trennfolie 6, Trennblech 3, neuerlich Trennfolie 6 und mit Kunstharz 4 beschichtete Kupferfolie 5, wird im Vorhinein zur Verbundkomponente 1 zusammengefügt, wie dies nachstehend anhand der Figuren 2 und 3 einerseits bzw. 4 und 5 andererseits in zwei Ausführungsbeispielen näher erläutert werden wird.

Die mit Harz 5 beschichteten Kupferfolien 4 der Verbundkomponenten 1 werden Bestandteil der Multilayer-Leiterplatten, zu denen weiters geätzte Innenlagen 7 (Basismaterialien) und Kunstharzschichten (Prepreg-Schichten) 8 der Anordnungen 2 gehören.

Dadurch, dass derartige Trennplatten-Verbundkomponenten 1 als Einheiten vorgesehen und beim Herstellen der Leiterplatten(komponenten) abwechselnd mit den Multilayer-Einzellagen übereinander gestapelt werden können, wird das Stapeln in der Presse wesentlich vereinfacht, da fünf Komponenten - 4/5;6;3;6;5/4 - in einem einzigen Vorgang auf einmal gelegt werden können. Dies reduziert die Handlingzeit wesentlich. Die geätzten Innenlagen 7 realisieren die gewünschte Schaltung bzw. Leiterstruktur, und sie werden mit Hilfe der Prepreg-Schichten 8 miteinander verklebt. Dieses Verbinden erfolgt in einer Presse bei erhöhter Temperatur sowie bei Druck oder aber Vakuum. In einem solchen Presspaket, wie es schematisch zum Teil in Fig. 1 veranschaulicht ist, können durchaus 20 Anordnungen 2 übereinander geschichtet sein. Zwischen den einzelnen Anordnungen 2 werden die Trennblech-Verbundkomponenten 1 gelegt, wobei die Trennbleche 3 für eine glatte, saubere Oberfläche der hergestellten Multilayer-Leiterplatten sorgen.

Während des definierten Presszyklus beginnt das Kunstharz der Prepreg-Schichten 8 zu fließen. Dadurch, dass die Antihaftlagen oder Trennlagen 6 vorgesehen sind, wird jedoch verhindert, dass das Harz der Schichten 8 auf die Trennbleche oder allgemein Trennplatten 3 gelangt. In diesem Zusammenhang muss auch verhindert werden, dass das Harz zu den Kanten der Trennplatten 3 fließt.

In der Ausführungsform gemäß Fig. 2 und 3 sind gesonderte Trennfolien als Antihaftlagen 6 vorgesehen, und diese Trennfolien 6 sind größer als die Trennplatte 3 und auch größer als die Kupferfolien 5 mit den Harzschichten 4. Wie aus Fig. 2 ersichtlich, sind in diesem Fall die Kupferfolien 5 und die Trennplatte 3 bevorzugt gleich groß, auch wenn die Kupferfolien 5 geringfügig kleiner sein können als die Trennplatte 3. Wichtig ist jedoch, dass die Trennfolien 6 allseitig über die Trennplatte 3 vorstehen, um so das flüssige Harz aufzufangen. Damit das Harz auch nicht zwischen den Trennfolien 6 zur Trennplatte 3 gelangen kann, sind die Trennfolien 6 miteinander längs einer Klebenaht 9 mit Hilfe eines druckempfindlichen Klebers, eines Acrylatklebers bzw. eines Schmelzklebers verbunden. Dadurch ist die Trennplatte 3 zwischen den sackartig miteinander verbundenen Trennfolien 6 eingeschlossen, das heißt die Trennplatte 3 liegt in einem Trennfoliensack vor, wobei sie in diesem Trennfoliensack frei beweglich angeordnet ist.

Die Kupferfolien 5 sind andererseits ebenfalls mit Hilfe von Klebern, z.B. Schmelzklebern, insbesondere Heißschmelzklebern, oder Acrylatklebern in der Art einer Klebenaht 10 an den Trennfolien 6 angeklebt.

Bei der Herstellung einer derartigen Trennplatten-Verbundkomponente 1 gemäß Fig. 2 und 3 wird die Trennplatte 3 auf die untere, größere Trennfolie 6 gelegt, und es wird die Klebenaht 9 auf dieser unteren Trennfolie 6 aufgebracht. Anschließend wird die obere Trennfolie 6 über die Trennplatte 3 und die untere Trennfolie 6 aufgelegt, und sie wird an die Klebenaht 9 auf der unteren Trennfolie 6 angedrückt. Damit ist die Trennplatte 3 in dem gebildeten Trennfoliensack geschützt, und sie kann nicht mehr verschmutzen. Danach werden die mit Harz 4 beschichteten Kupferfolien 5 mit der Kupferseite, der sogenannten Shiny-Seite, auf die obere bzw. untere Trennfolie 6 geklebt, wobei die Klebenaht 10 randseitig außen umlaufend vorliegt. Die Harzseite, d.h. die Harzschichten 4, sind den benachbarten Anordnungen 2 zugewandt, siehe Fig. 1, und die harzbeschichteten Kupferfolien 5 können somit einen Teil der herzustellenden Leiterplatten bilden.

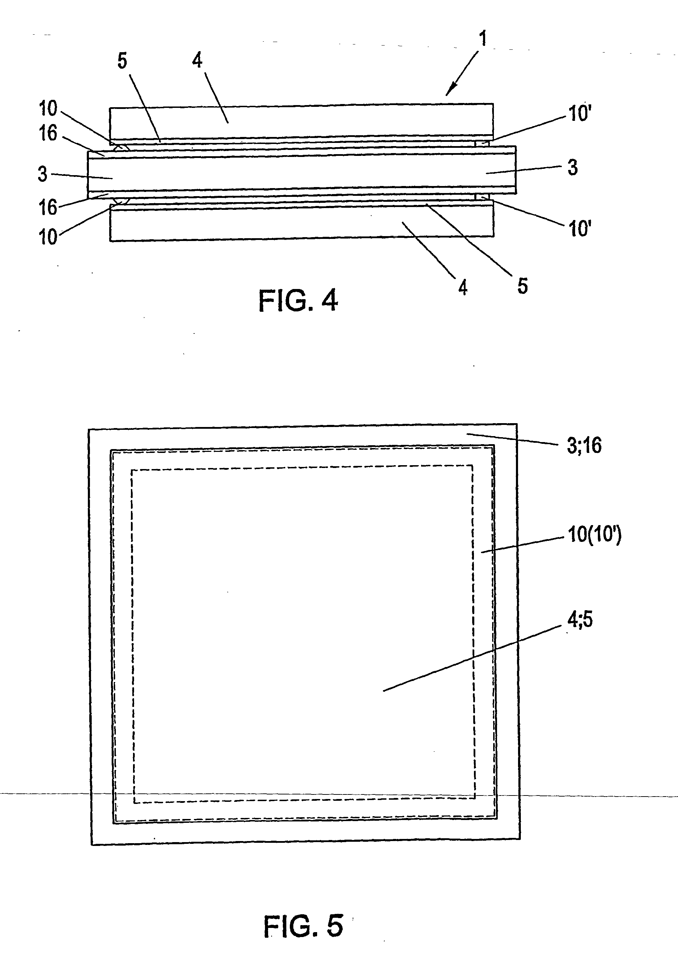

In der Variante gemäß Fig. 4 und 5 wird eine Trennplatte 3 eingesetzt, die größer ist als die Kupferfolien 5, und die allseitig über deren Ränder vorsteht. Die Trennplatte 3 ist in diesem Ausführungsbeispiel gemäß Fig. 4 und 5 direkt mit einer Antihaft-Beschichtung 16 beschichtet, die wiederum zum Auffangen des beim Pressen ausfließenden Harzes der Prepreg-Schichten 8 dient. Dieses Auffangen von Harz ist dadurch möglich, weil die Trennplatte 3 hier größer ist als der übrige Laminat-Aufbau. Die Kupferfolien 5 sind wieder über Klebenähte 10 auf den Antihaft-Beschichtungen 16 auf der Trennplatte 3 randseitig aufgeklebt. Als Material für die Antihaft-Beschichtungen kann mit Vorteil ein auf.Wasserbasis aufgebautes (Poly)Olefin, wie das im Handel erhältliche Produkt TUF-LUBE 3C, eine Polyolefin-Emulsion der Fa. Tadco Inc., Woodinville, WA, USA, verwendet werden. Ein solches Olefin wird deshalb bevorzugt, weil es Silikon-frei und äußerst umweltfreundlich ist. Die Trennplatten 3 können aus jedem geeigneten Material bestehen, wie z.B. aus Stahl, insbesondere Edelstahl, aber auch aus Aluminium. Bevorzugt wird ein Metall, wie Stahl, mit einer Mindestfestigkeit von 400 MPa, um einen sog. Imagetransfer zu vermeiden.

Die Trennfolien 6 können aus jedem geeigneten Kunststoffmaterial bestehen, wie z.B. aus PET oder Fluorpolymeren.

Als Kleber für die Klebenähte 9 bzw. 10 können herkömmliche druckempfindliche Kleber bzw. Schmelzkleber, wie insbesondere der unter der Bezeichnung TSP353M im Handel erhältliche Kleber von ATO FINNEY, eingesetzt werden. Bevorzugt werden Acrylatkleber, wie z.B. der unter der Bezeichnung DELO-CA® im Handel erhältliche Kleber auf Alkoxy-alkyl-Basis der Firma DELO Industrie Klebstoffe, Landsberg, Deutschland, eingesetzt, die sich beim Verpressen zersetzen, d.h. ihre Klebewirkung verlieren.

Mit der beschriebenen Anbringung von Trennfolien 6 bzw. Trennschichten oder Antihaft-Beschichtungen als das Kunstharz beim Pressen auffangende Antihaftlagen 6 wird ein Verschmutzen der Trennplatten bzw. Trennbleche 3 sicher vermieden. Dadurch wird eine mehrmalige Verwendung dieser Trennplatten 3 ohne Probleme ermöglicht, wobei insbesondere die bisher erforderlichen mühsamen Reinigungsvorgänge zum Abschaben von Kunstharz entfallen können. Andererseits wird die Verwendung von Kunstharz-beschichteten Kupferfolien 5 ermöglicht, was die Leiterplattenherstellung begünstigt.

## Patentansprüche

1. Trennplatten-Verbundkomponente (1) zum Herstellen von Leiterplatten-Komponenten unter Verpressen von mit zumindest einer solchen Verbundkomponente gestapelten Einzellagen (7, 8), welche Verbundkomponente (1) eine Trennplatte (3) zwischen Kupferfolien (5) aufweist, **dadurch gekennzeichnet, dass** an der Trennplatte (3), zwischen dieser und den Kupferfolien (5), Antihaftlagen (6) angeordnet sind, wobei die Kupferfolien (5) an den Antihaftlagen (6) angeklebt sind.

2. Verbundkomponente nach Anspruch 1, **dadurch gekennzeichnet, dass** die Kupferfolien (5) auf ihren von den Antihaftlagen (6) abgelegenen Seiten mit Harz (4) beschichtet sind.

3. Verbundkomponente nach Anspruch 1 oder 2, **dadurch gekennzeichnet, dass** die Kupferfolien (5) an den Antihaftlagen (6) mit Hilfe eines Schmelzklebers, z.B. Heißschmelzklebers, angeklebt sind.

4. Verbundkomponente nach Anspruch 1 oder 2, **dadurch gekennzeichnet, dass** die Kupferfolien (5) an den Antihaftlagen (6) mit Hilfe eines Acrylatklebers angeklebt sind.

5. Verbundkomponente nach einem der Ansprüche 1 bis 4, **dadurch gekennzeichnet, dass** die Trennplatte (3) ein Stahlblech ist.

6. Verbundkomponente nach einem der Ansprüche 1 bis 5, **dadurch gekennzeichnet, dass** die Antihaftlagen (6) durch gesonderte Trennfolien gebildet sind, die mit einem Randbereich über die Trennplatte (3) vorstehen und in diesen vorstehenden Randbereichen miteinander verbunden sind, wodurch die Trennplatte (3) in einem Trennfoliensack eingeschlossen ist.

7. Verbundkomponente nach Anspruch 6, **dadurch gekennzeichnet, dass** die Trennplatte (3) im Inneren des Trennfoliensacks frei beweglich ist.

8. Verbundkomponente nach Anspruch 6 oder T, **dadurch gekennzeichnet, dass** die beiden Trennfolien (6) über eine Klebenaht (9) miteinander verbunden sind.

9. Verbundkomponente nach einem der Ansprüche 1 bis 5, **dadurch gekennzeichnet, dass** die Antihaftlagen (6) durch auf den beiden Seiten der Trennplatte (3) aufgebrachte Antihaft-Beschichtungen (16) gebildet sind, und dass die Trennplatte (3) samt Antihaft-Beschichtungen über die Kupferfolien (5) allseitig vorsteht.

10. Verbundkomponente nach Anspruch 9, **dadurch gekennzeichnet, dass** die Antihaft-Beschichtungen (16) aus Teflon gebildet sind.

11. Verbundkomponente nach Anspruch 9, **dadurch gekennzeichnet, dass** die Antihaft-Beschichtungen (16) aus einem Polyolefin gebildet sind.

12. Verbundkomponente nach Anspruch 9, **dadurch gekennzeichnet dass** die Antihaft-Beschichtungen (16) aus einem Lack bestehen.

13. Verfahren zum Herstellen einer Trennplatten-Verbundkomponente (1) zur Verwendung bei der Herstellung von Leiterplatten-Komponenten unter Verpressen von mit zumindest einer solchen Verbundkomponente gestapelten Einzellagen (7, 8), welche Verbundkomponente (1) eine Trennplatte (3) zwischen Kupferfolien (5) aufweist, **dadurch gekennzeichnet, dass** eine Trennplatte (3) auf eine vergleichsweise größere Antihaft-Trennfolie (6) aufgelegt und eine Klebenaht (9) umlaufend auf die Trennfolie (6) aufgebracht wird, wonach eine obere, ebenfalls im vergleich zur Trennplatte (3) größere Antihaft-Trennfolie (6) aufgelegt und mit dem über die Trennplatte (3) vorstehenden Randbereich an der Klebenaht (9) angedrückt wird, wonach Kupferfolien (5) auf die Trennfolien (6) aufgeklebt werden.

14. Verfahren nach Anspruch 13, **dadurch gekennzeichnet, dass** die Klebenaht (9) mit Hilfe eines Schmelzklebers hergestellt wird.

15. Verfahren nach Anspruch 13, **dadurch gekennzeichnet, dass** die Klebenaht (9) mit Hilfe eines Acrylatklebers hergestellt wird.

## Claims

1. A separating plate compound component (1) for producing printed circuit board components by compressing individual layers (7, 8) stacked with at least one such compound component, which compound component (1) includes a separating plate (3) between copper foils (5), **characterised in that** anti-adhesive-layers (6) are arranged on the separating plate (3) between the latter and the copper foils (5), the copper foils (5) being glued to the anti-adhesive layers (6).

2. A compound component according to claim 1, **characterised in that** the copper foils (5) are coated with resin (4) on their faces remote from the anti-adhesive layers (6).

3. A compound component according to claim 1 or 2, **characterised in that** the copper foils (5) are glued to the anti-adhesive layers (6) by means of a thermoplastic adhesive, e.g. a hot melt-type adhesive.

4. A compound component according to claim 1 or 2, **characterised in that** the copper foils (5) are glued to the anti-adhesive layers (6) by means of an acrylate adhesive.

5. A compound component according to any one of claims 1 to 4, **characterised in that** the separating plate (3) is a steel sheet.

6. A compound component according to any one of claims 1 to 5, **characterised in that** the anti-adhesive layers (6) are formed by separate separator foils, projecting with a rim region beyond the separating plate (3) and being interconnected in these projecting rim regions, whereby the separating plate (3) is enclosed in a separator foil bag.

7. A compound component according to claim 6, **characterised in that** the separating plate (3) is freely movable within the separator foil bag.

8. A compound component according to claim 6 or 7, **characterised in that** the two separator foils (6) are interconnected via an adhesive seam (9).

9. A compound component according to any one of claims 1 to 5, **characterised in that** the anti-adhesive layers (6) are formed by anti-adhesive coatings (16) applied on both sides of the separating plate (3), and that the separating plate (3) including the anti-adhesive coatings project beyond the copper foils (5) on all sides thereof.

10. A compound component according to claim 9, **characterised in that** the anti-adhesive coatings (16) are made of Teflon.

11. A compound component according to claim 9, **characterised in that** the anti-adhesive coatings (16) are made of a polyolefin.

12. A compound component according to claim 9, **characterised in that** the anti-adhesive coatings (16) are made of varnish.

13. A method of producing a separating plate compound component (1) to be used in the production of printed circuit board components by compressing individual layers (7, 8) stacked with at least one such compound component, which compound component (1) includes a separating plate (3) between copper foils (5), **characterised in that** a separating plate (3) is laid on a comparatively larger anti-adhesive separator foil (6) and an adhesive seam (9) is peripherally applied to the separator foil (6), whereupon an upper anti-adhesive separator foil (6) which also is larger as compared to the separating plate (3) is laid thereon and is pressed with its rim region that projects over the separating plate (3) at the adhesive seam (9), whereafter copper foils (5) are glued to the separator foils (6).

14. A method according to claim 13, **characterised in that** the adhesive seam (9) is produced by means of a thermoplastic adhesive.

15. A method according to claim 13, **characterised in that** the adhesive seam (9) is made by means of an acrylate adhesive.

## Revendications

1. Composant composite à plaque de séparation (1) pour la fabrication de composants de plaquettes par l'intermédiaire d'une compression de monocouches (7, 8) empilées avec au moins un tel composant composite, lequel composant composite (1) présente une plaque de séparation (3) entre des feuilles de cuivre (5), **caractérisé en ce que** des couches anti-adhérentes (6) sont agencées au niveau de la plaque de séparation (3), entre celle-ci et les feuilles de cuivre (5), les feuilles de cuivre (5) étant collées aux couches anti-adhérentes (6).

2. Composant composite selon la revendication 1, **caractérisé en ce que** les feuilles de cuivre (5) sont revêtues de résine (4) sur les côtés enlevés par les couches anti-adhérentes (6).

3. Composant composite selon la revendication 1 ou 2, **caractérisé en ce que** les feuilles de cuivre (5) sont collées aux couches anti-adhérentes (6) à l'aide d'une colle fusible, par exemple une colle thermofusible .

4. Composant composite selon la revendication 1 ou 2, **caractérisé en ce que** les feuilles de cuivre (5) sont collées aux couches anti-adhérentes (6) à l'aide d'une colle acrylate.

5. Composant composite selon les revendications 1 à 4, **caractérisé en ce que** la plaque de séparation (3) est une tôle d'acier.

6. Composant composite selon l'une quelconque des revendications 1 à 5, **caractérisé en ce que** les couches anti-adhérentes (6) sont formées à partir de films de séparation assortis, lesquels font saillie avec leur surface de rebord au-dessus la plaque de séparation (3) et sont reliés les uns aux autres au niveau de ces surfaces de rebord, par l'intermédiaire desquels la plaque de séparation (3) est enfermée dans un sac de films de séparation.

7. Composant composite selon la revendication 6, **caractérisé en ce que** la plaque de séparation (3) est mobile librement à l'intérieur du sac de films de séparation.

8. Composant composite selon la revendication 6 ou 7, **caractérisé en ce que** les deux films de séparation (6) sont reliés entre eux par l'intermédiaire d'une couture adhésive (9).

9. Composant composite selon l'une quelconque des revendications 1 à 5, **caractérisé en ce que** les couches anti-adhérentes (6) sont formées par l'intermédiaire de revêtements anti-adhérents (16) disposés sur les deux côtés de la plaque de séparation (3), et que la plaque de séparation (3) fait saillie au niveau de tous les côtés, ensemble avec les revêtements anti-adhérents, au-dessus des feuilles de cuivre (5).

10. Composant composite selon la revendication 9, **caractérisé en ce que** les revêtements anti-adhérents (16) sont constitués de Téflon.

11. Composant composite selon la revendication 9, **caractérisé en ce que** les revêtements anti-adhérents (16) sont constitués d'une polyoléfine.

12. Composant composite selon la revendication 9, **caractérisé en ce que** les revêtements anti-adhérents (16) sont composés d'une laque.

13. Procédé de fabrication d'un composant composite à plaque de séparation (1) pour son utilisation lors de la fabrication de composants de plaquettes par l'intermédiaire d'une compression de monocouches (7, 8) empilées avec au moins un tel composant composite, lequel composant composite (1) comportant une plaque de séparation (3) entre des feuilles de cuivre (5), **caractérisé en ce qu'**une plaque de séparation (3) est disposée sur un film de séparation anti-adhérent (6) comparativement plus grand, et qu'une couture d'adhésion (9) est appliquée tout autour du film de séparation (6), d'après lequel, un film de séparation anti-adhérent supérieur (6), également comparativement plus grand que la plaque de séparation (3), est disposé et pressé, ensemble avec la surface de rebord en saillie, au-dessus de la plaque de séparation (3), au niveau de la couture adhésive (9), d'après laquelle des feuilles de cuivre (5) sont collées sur les films de séparation (6).

14. Procédé selon la revendication 13, **caractérisé en ce que** la couture adhésive (9) est fabriquée à l'aide d'une colle fusible.

15. Procédé selon la revendication 13, **caractérisé en ce que** la couture adhésive (9) est fabriquée à l'aide d'une colle acrylate.
